# EUROPEAN PATENT SPECIFICATION

(11) **EP 1 604 331 B1**
(45) Date of publication and mention of the grant of the patent: **19.11.2008**
(21) Application number: 04718362.9
(22) Date of filing: 08.03.2004
(51) Int. Cl.: G06K 19/077

(54) **DUAL INTERFACE MICRO-MODULE TESTABLE ON REEL**
AUF SPULE PRÜFBARES DOPPELSCHNITTSTELLENMIKROMODUL
MICROMODULE A DOUBLE INTERFACE POUVANT ETRE TESTE SUR BOBINE

(30) Priority: 06.03.2003 EP 03290543
(43) Date of publication of application: 14.12.2005
(73) Proprietor: Axalto S.A., 92190 Meudon (FR); Schlumberger Malco, Inc., Owings Mills, MD 21117 (US)
(72) Inventor: LE LOC'H, Alain, F-78000 Versailles (FR)
(74) Representative: Cour, Pierre
(86) International application number: PCT/IB2004/000622
(87) International publication number: WO 2004/079647

(56) References cited:
- WO-A-98/33143
- DE-A- 19 640 303

## Description

### FIELD OF THE INVENTION

The invention relates to a design of printed circuit for dual interface micro-module, which allows the testing of the contact interface and the contact-less interface, e.g. Radio Frequency (RF) interface of the micro-module. The invention also relates to a method for testing a dual interface micro-module and a method for manufacturing a smart-card.
A dual interface micro-module comprises a semiconductor chip connected to a contact interface and a contact-less interface. Such a micro-module is intended to be embedded in a plastic card (smart card), an antenna embedded in the plastic card being connected to the contact-less interface of the micro module.

### BACKGROUND OF THE INVENTION

It is know for mass manufacturing of dual interface micro-modules to use the manufacturing technology of printed circuit on reel. Such a dual-interface micro-module manufacturing technology is disclosed in document DE 19640303A. Such printed circuit are for example manufactured and commercialized by the Applicant under the reference Dofa14. The printed circuit is constituted of a multi-layer: one central and perforated insulating layer and two conductive copper based layers, one on each side of the central layer. Each dual interface micro-module which is punched out of the reel, is subsequently connected to an antenna and embedded in a plastic card body. The contact interface is arranged on one side of the printed circuit. This side is the one on which the contact plates of the contact interface of the final smart card will be connected in order to enable a connection with a known smart-card reader terminal. The contact-less interface is arranged on the opposite side of the printed circuit. This side is the one which will be embedded in the card.

When semi-finish dual interface micro-modules on reel are sold to customers (semi-finish in the sense that the dual interface micro-modules still has to be embedded in a card body with an integrated antenna), each micro-module has to be fully tested in order to detect any defective interface and/or semiconductor chip. For dual interface micro-modules delivered in reels, either the micro-module testing is performed on the complete card once manufactured, or the micro-modules is fully tested (including the contact-less interface) before being embedded in card.
One solution for testing before embedding is to access the contacts plate on one side of the printed circuit and the contact-less, e.g. RF part on the opposite side.
Such a testing method requires:
- either to pass twice the reel in a simple test handler machine, first the contacts up, then the contacts down,
- or a more complex machine able to manage electrical pins contact on both side (upper and lower side) of the printed circuit.
The testing of the module on reel is performed in manufacturing plants by testing machines. A testing machine is able to manage eight electrical pins going on contact plates and connected to an electrical coupler device.
ISO 7816 compliant smart card comprises a micro-module having height contact plates, six contact plates being used by the contact interface. Generally, the testing machine uses five to six electrical pins for testing the contact interface.

### SUMMARY OF THE INVENTION

One goal of the invention is to propose a simple way of micro-module dual interface testing.
According to the invention, two electrical pins which remind unused for the contact interface testing are used for the contact-less, e.g. RF, interface testing. These pins are going to be used for a temporary connection with the RF interface.
According to the invention, a particular printed circuit design allows to recover temporarily the two input-output of the contact-less interface on the upper side (contact plates side) of the printed circuit. With two electrical pins connected to an antenna simulation device, it becomes possible to directly test the semiconductor chip contact-less RF interface at the same time the contact interface is tested and with a substantially identical testing machine or at least a machine requiring minor modification.
The connection between metallic areas planned for the electrical connection of an antenna integrated in a plastic card body, and the contact plates, is assured with the combination of wires bonded through blind holes and copper leads with some portions located outside the micro-module punching limit.

With this design, the punching of the micro-module before embedding destroys the possible access to the RF interface through the contact plates.
As the connection disappears, when the smart card is used, both electrical perturbation with manual handling (fingers on contact plates) and possible access to contact-less interface through the contact plates are avoided.

More precisely, the present invention relates to a printed circuit comprising:
a) a first surface comprising:
   - a micro-module of dual-interface type, the dual-interface comprises a contact interface and a contact-less interface, the contact interface comprising first contact areas disposed on a upper side of the printed circuit and the contact-less interface comprising second contact areas disposed on a lower side of the printed circuit,
   - a chip connected to the first contact areas of the contact interface and to the second contact areas of the contact-less interface, and
b) a second surface encompassing the first surface,
wherein the second surface of the printed circuit comprises a connection means connecting the second contact areas of the contact-less interface to a part of the first contact areas of the contact interface.

The invention also relates to a method for testing a micro-module of dual-interface type, the dual-interface comprises a contact interface and a contact-less interface, the contact interface comprising first contact areas disposed on a upper side of a printed circuit and the contact-less interface comprising second contact areas disposed on a lower side of the printed circuit, both interface being connected to a chip, the micro-module being disposed on a first surface,
the method for testing the micro-module comprises the steps of :
a) connecting the second contact areas of the contact-less interface to a part of the first contact areas of the contact interface by connection means passing through a second surface encompassing the first surface,
b) testing the contact interface and the contact-less interface connected to the chip through the first contact areas, and
c) punching the first surface out of the second surface.

The contact-less interface testing can be performed concomitantly with the contact interface testing, shortly before or shortly after.

Finally, the invention also relates to a method for manufacturing a dual interface smart-card, comprising the steps of :
a) manufacturing a dual interface micro-module,
b) testing the dual interface micro-module according to the method for testing a micro-module of dual-interface type of the invention,
c) connecting an antenna to the contact-less interface of the micro-module,
d) embedding the micro-module with its connected antenna into a plastic card.

### BRIEF DESCRIPTION OF THE DRAWINGS

The present invention is illustrated by way of example and not limited to the accompanying figures, in which like references indicate similar elements :
Figure 1 schematically illustrates a chip side view of a printed circuit design according to the present invention ;
Figure 2 schematically illustrates the test principle of the dual interface micro-module according to the present invention ;
Figure 3 schematically illustrates a chip side view of a printed circuit design according to an alternative embodiment of the present invention.

### DETAILED DESCRIPTION OF THE INVENTION

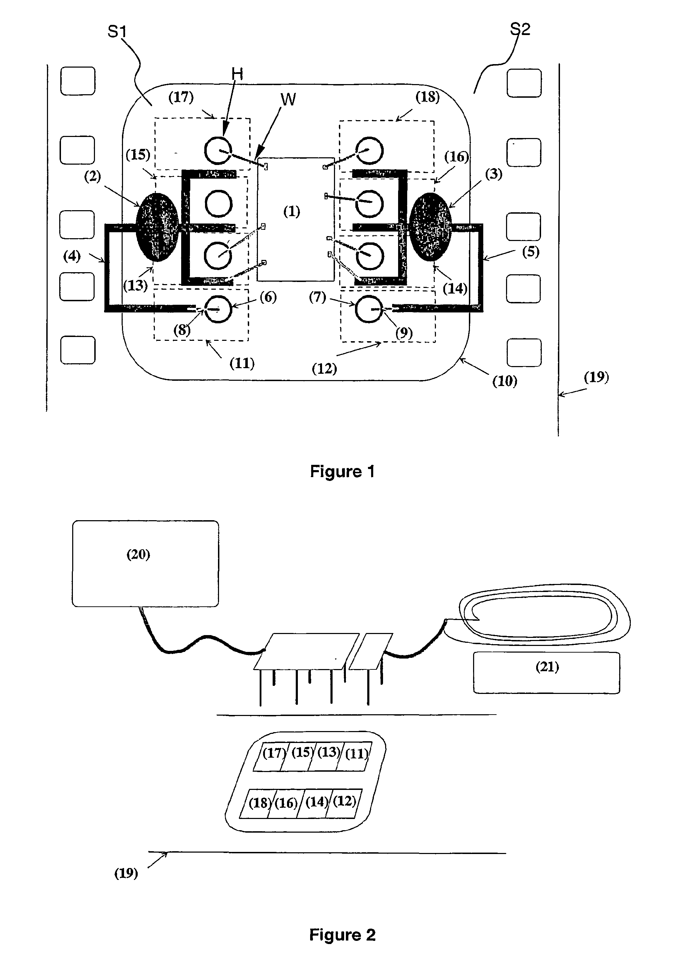

A chip side view of a printed circuit design according to a first embodiment of the invention is schematically shown on Figure 1. The printed circuit 19 is adapted to be fitted on a reel (a reel of printed circuits comprises at least two printed circuits). The printed circuit 19 comprises metallic contact plates 11, 12, 13, 14, 15, 16, 17, 18 on one side of the printed circuit, and two metallic areas 2 and 3 on the other side of the printed circuit. A semiconductor chip 1 glued to the printed circuit is connected to the contacts plate through wires W (only one is referenced for drawing clarity) and blind holes H (only one is referenced for drawing clarity). The two metallic areas 2 and 3 will be used for the electrical connection of an antenna integrated (not represented) in a plastic card body (not represented) and the glued chip 1. The metallic contact plates 11 and 12 are connected to the chip contact-less, e.g. RF, interface through two wires 8 and 9 and two blind holes 6 and 7. According to the invention, the electrical conductive parts 4 and 5 connecting the metallic areas to some of the contact plates are placed outside the punched module limit 10.

As schematically illustrated on Figure 2, the test of the contact interface and the contact-less interface is possible with the height pins of the testing machine. The contact interface testing is performed by using an electrical coupler 20 connected through electrical pins to the six metallic contact plates 13, 14, 15, 16, 17, 18. The contact-less, e.g. RF, interface testing is performed with another electrical coupler simulating the antenna 21 connected through electrical pins to the two metallic contact plates 11 and 12.

When the micro-module is punched out of the reel of integrated circuits according to the punching limit 10, the connection between the semiconductor chip RF interface and the metallic contacts areas 11 and 12 are destroyed.
When the micro-module is embedded in plastic card, there is no physical possibility to access the RF interface through the contact plates side. Thus, there is also no possibility of electrical interference with the chip or electrical perturbations generated by the contact plates, for example by placing the smart-card user fingers on the metallic contact plates.

The micro-module of Figure 1 is advantageously compatible with a possible use in a mobile telecommunication handset in which the antenna is integrated in the handset.

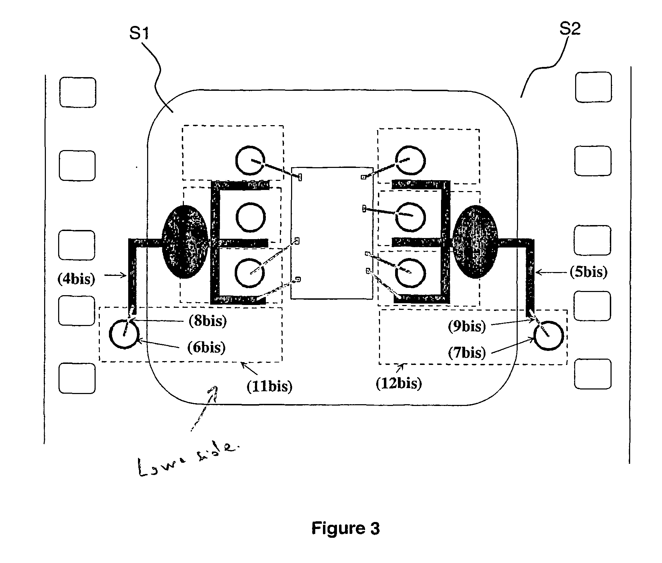

A chip side view of a printed circuit design according to a second embodiment of the invention is schematically shown on Figure 3.
This alternative solution enables to perform a connection between the semiconductor chip RF interface and the metallic contact plates 11 bis and 12bis. In this case the wires 6bis and 7bis and the blind holes 8bis and 9bis are located outside the punching limit. The connection will be destroyed after punching. Also, the wires 6bis and 7bis and the blind holes do not stay with the micro-module after punching.

With the design of the printed circuit according to the present invention, the manufacturing process remains the same. In particular, the testing machine do not need to be physically modified except for the minor adjunction of a simulating antenna for connection to the two electrical pins connecting to the chip RF interface.
Advantageously, the modules are completely tested before any embedding and thus only the good parts are embedded. This enables a reduction of the manufacturing cost of the complete smart card by reducing the defects rate due to defectuous contact-less interface and/or chip in the micro-modules.

## Claims

1. A printed circuit (19) comprising :
a) a first surface (S1) comprising :
- a micro-module of dual-interface type, the dual-interface comprises a contact interface and a contact-less interface, the contact interface comprising first contact areas (11, 12, 13, 14, 15, 16, 17, 18) disposed on a upper side of the printed circuit (19) and the contact-less interface comprising second contact areas (2, 3) disposed on a lower side of the printed circuit (19),
- a chip (1) connected to the first contact areas (11, 12, 13, 14, 15, 16, 17, 18) of the contact interface and to the second contact areas (2, 3) of the contact-less interface, and
b) a second surface (S2) encompassing the first surface (S1),
wherein the second surface (S2) of the printed circuit (19) comprises a connection means (4, 5, 4bis, 5bis) connecting the second contact areas (2, 3) of the contact-less interface to a part of the first contact areas (11, 12, 13, 14, 15, 16, 17, 18) of the contact interface.

2. A printed circuit according to previous claim, wherein the first surface (S1) is delimited by a punching limit (10).

3. A printed circuit according to any one of the previous claims, wherein at least a part of the first contact areas (11 bis, 12bis) are extending into the second surface (S2).

4. A printed circuit according to any one of the previous claims, wherein the first contact areas are constituted by contact plates (11, 11 bis, 12, 12bis, 13, 14, 15, 16, 17, 18).

5. A printed circuit according to any one of the previous claims, wherein the chip (1) is connected to the first contact areas (11,12,13,14,15,16,17,18) of the contact interface by wires (W) and blind holes (H).

6. A printed circuit according to any one of the previous claims, wherein the connection means (4, 5, 4bis, 5bis) comprises wires (8, 9 ; 8bis, 9bis) and blind holes (6, 7 ; 6bis, 7bis).

7. A reel of printed circuits wherein the reel comprises at least two printed circuits according to any one of the previous claims.

8. A method for testing a micro-module of dual-interface type, the dual-interface comprises a contact interface and a contact-less interface, the contact interface comprising first contact areas (11,12,13,14,15,16,17,18) disposed on a upper side of a printed circuit (19) and the contact-less interface comprising second contact areas (2, 3) disposed on a lower side of the printed circuit (19), both interface being connected to a chip (1), the micro-module being disposed on a first surface (S1),
the method for testing the micro-module comprises the steps of :
a) connecting the second contact areas (2, 3) of the contact-less interface to a part of the first contact areas (11, 12, 13, 14, 15, 16, 17, 18) of the contact interface by connection means passing through a second surface (S2) encompassing the first surface,
b) testing the contact interface and the contact-less interface connected to the chip through the first contact areas (11,12,13,14,15,16,17,18), and
c) punching the first surface (S1) out of the second surface (S2).

9. A method for testing a micro-module of dual-interface type according to the previous claim, wherein the contact-less interface testing is performed concomitantly with the contact interface testing.

10. A method for testing a micro-module of dual-interface type according to the previous claim, wherein the contact-less interface testing is performed through a simulated antenna (21).

11. A method for manufacturing a dual interface smart-card, comprising the steps of :
a) manufacturing a dual interface micro-module,
b) testing the dual interface micro-module,
c) connecting an antenna to the contact-less interface of the micro-module,
d) embedding the micro-module with its connected antenna into a plastic card,
wherein the micro-module is tested according to claims 8 to 10.

## Patentansprüche

1. eine gedruckte Schaltung (19), die aus den folgenden Elementen besteht:
a) einer ersten Oberfläche (S1), die aus den folgenden Elementen besteht:
- einem Doppelschnittstellenmikromodul, die Doppelschnittstelle besteht aus einer Kontaktschnittstelle und kontaktlosen Schnittstelle, wobei die Kontaktschnittstelle aus ersten Kontaktflächen (11, 12, 13, 14, 15, 16, 17 und 18) besteht, die auf der oberen Seite der gedruckten Schaltung (19) angeordnet sind, und die kontaktlose Schnittstelle aus zweiten Kontaktflächen (2, 3) besteht, die auf der unteren Seite der gedruckten Schaltung (19) angeordnet sind.
- einem Chip (1), der mit den ersten Kontaktflächen (11, 12, 13, 14, 15, 16, 17 und 18) der Kontaktschnittstelle und den zweiten Kontaktflächen (2, 3) der kontaktlosen Schnittstelle verbunden ist, sowie
b) einer zweiten Oberfläche (S2), welche die erste Oberfläche (S1) umfasst,
wobei die zweite Oberfläche (S2) der gedruckten Schaltung (19) ein Verbindungselement umfasst (4, 5, 4bis, 5bis), welches die zweiten Kontaktflächen (2, 3) der kontaktlosen Schnittstelle mit einem Teil der ersten Kontaktflächen (11, 12, 13, 14, 15, 16, 17 und 18) der Kontaktschnittstelle verbindet.

2. Eine gedruckte Schaltung gemäß dem vorherigen Anspruch, wobei die erste Oberfläche (S1) durch eine Ausstanzgrenze (10) begrenzt wird.

3. Eine gedruckte Schaltung gemäß einem vorherigen Anspruch, wobei mindestens ein Teil der ersten Kontaktflächen (11 bis, 12bis) in die zweite Oberfläche (S2) hineinreicht.

4. Eine gedruckte Schaltung gemäß einem vorherigen Anspruch, wobei die ersten Kontaktflächen aus Kontaktplatten (11, 11 bis, 12, 12bis, 13, 14, 15, 16, 17, 18) bestehen.

5. Eine gedruckte Schaltung gemäß einem vorherigen Anspruch, wobei der Chip (1) durch Drähte (W) und Blindlöcher (H) mit den ersten Kontaktflächen (11, 12, 13, 14, 15, 16, 17 und 18) der Kontaktschnittstelle verbunden ist.

6. Eine gedruckte Schaltung gemäß einem vorherigen Anspruch, wobei das Verbindungselement (4, 5, 4bis, 5bis) Drähte (8, 9, 8bis, 9bis) und Blindlöcher (6, 7, 6bis, 7bis) umfasst.

7. Eine Spule von gedruckten Schaltungen, wobei die Spule mindestens zwei gemäß einem vorherigen Anspruch gedruckte Schaltungen umfasst.

8. Eine Methode zur Prüfung eines Doppelschnittstellenmikromoduls, wobei die Doppelschnittstelle aus einer Kontaktschnittstelle und einer kontaktlosen Schnittstelle besteht, wobei die Kontaktschnittstelle aus ersten Kontaktflächen (11, 12, 13, 14, 15, 16, 17 und 18) besteht, die auf der oberen Seite der gedruckten Schaltung (19) angeordnet sind, und die kontaktlose Schnittstelle aus zweiten Kontaktflächen (2, 3) besteht, die auf der unteren Seite der gedruckten Schaltung (19) angeordnet sind, und beide Schnittstellen mit dem Chip (1) verbunden sind und das Mikromodul an einer ersten Oberfläche (S1) angeordnet ist.
Die Methode zur Prüfung der Mikromodule umfasst die folgenden Schritte:
a) Verbindung der zweiten Kontaktflächen (2, 3) der kontaktlosen Schnittstelle mit einem Teil der ersten Kontaktflächen (11, 12, 13, 14, 15, 16, 17 und 18) der Kontaktschnittstelle mittels Verbindungselement, welches durch die zweite Oberfläche (S2), welche die erste Oberfläche umfasst, durchgeht.
b) Prüfung der Kontaktschnittstelle und der kontaktlosen Schnittstelle, welche durch den Chip verbunden sind, durch die ersten Kontaktflächen (11, 12, 13,14,15,16,17 und 18) sowie
c) Ausstanzen der ersten Oberfläche (S1) durch die zweite Oberfläche (S2)

9. Eine Methode zur Prüfung der Doppelschnittstellenmikromodule gemäß dem vorherigen Anspruch, wobei die Prüfung der kontaktlosen Schnittstelle zusammen mit der Prüfung der Kontaktschnittstelle erfolgt.

10. Eine Methode zur Prüfung der Doppelschnittstellenmikromodule gemäß dem vorherigen Anspruch, wobei die Prüfung der kontaktlosen Schnittstelle mittels einer simulierten Antenne (21) erfolgt.

11. eine Methode zur Herstellung einer Chipkarte mit zwei Schnittstellen, welche aus den folgenden Schritten besteht:
a) Herstellung eines Doppelschnittstellenmikromoduls
b) Prüfung des Doppelschnittstellenmikromoduls
c) Anschluss einer Antenne an die kontaktlose Schnittstelle des Mikromoduls
Einbau des Mikromoduls mit der verbundenen Antenne in die Kunststoffkarte,
wobei das Mikromodul gemäß den Ansprüchen 8 bis 10 geprüft wird.

## Revendications

1. Un circuit imprimé (19) comprenant :
a) une première surface (S1) comprenant :
- un micromodule de type double interface, sachant que ladite double interface comprend une interface de contact et une interface sans contact, sachant que ladite interface de contact comprend des premières zones de contact (11, 12, 13, 14, 15, 16, 17, 18) disposées sur un côté supérieur du circuit imprimé (19) et sachant que l'interface sans contact comprend des secondes zones de contact (2, 3) disposées sur un côté inférieur du circuit imprimé (19),
- une puce (1) connectée aux premières zones de contact (11, 12, 13, 14, 15, 16, 17, 18) de l'interface de contact et aux secondes zones de contact (2,3) de l'interface sans contact, et
b) une seconde surface (S2) englobant la première surface (S1),
sachant que la seconde surface (S2) du circuit imprimé (19) comprend un moyen de connexion (4, 5, 4bis, 5bis) reliant les secondes zones de contact (2, 3) de l'interface sans contact à une partie des premières zones de contact (11, 12, 13, 14, 15, 16, 17, 18) de l'interface de contact.

2. Un circuit imprimé conformément à la revendication précédente, sachant que la première surface (S1) est délimitée par une limite de découpage (10).

3. Un circuit imprimé conformément aux revendications précédentes, sachant qu'au moins une partie des premières zones de contact (11bis, 12bis) s'étend sur la seconde surface (S2).

4. Un circuit imprimé conformément aux revendications précédentes, sachant que les premières zones de contact sont constituées de plots (11, 11 bis, 12, 12bis, 13, 14, 15, 16, 17, 18).

5. Un circuit imprimé conformément aux revendications précédentes, sachant que la puce (1) est connectée aux premières zones de contact (11, 12, 13, 14, 15, 16, 17, 18) de l'interface de contact par des câbles (W) et des trous borgnes (H).

6. Un circuit imprimé conformément aux revendications précédentes, sachant que le moyen de connexion (4, 5, 4bis, 5bis) comprend des câbles (8, 9, 8bis, 9bis) et des trous borgnes (6, 7, 6bis, 7bis).

7. Une bobine de circuits imprimés, sachant que la bobine comprend au moins deux circuits imprimés conformément aux revendications précédentes.

8. Une méthode servant à tester un micromodule de type double interface, sachant que ladite double interface comprend une interface de contact et une interface sans contact, sachant que ladite interface de contact comprend des premières zones de contact (11, 12, 13, 14, 15, 16, 17, 18) disposées sur un côté supérieur du circuit imprimé (19) et sachant que l'interface sans contact comprend des secondes zones de contact (2, 3) disposées sur un côté inférieur du circuit imprimé (19), les deux interfaces étant reliées à une puce (1), le micromodule étant disposé sur une première surface (S1) ;
La méthode de test du micromodule comprend les étapes suivantes :
- connexion des secondes zones de contact (2, 3) de l'interface sans contact à une partie des premières zones de contact (11, 12, 13, 14, 15, 16, 17, 18) de l'interface de contact à l'aide de moyens de connexion passant à travers une seconde surface (S2) englobant la première surface,
- test de l'interface de contact et de l'interface sans contact reliées à la puce par les premières zones de contact (11, 12, 13, 14, 15, 16, 17, 18), et
- découpe de la première surface (S1) hors de la seconde surface (S2).

9. Une méthode servant à tester un micromodule de type double interface conformément à la revendication précédente, sachant que le test de l'interface sans contact est réalisé en même temps que le test de l'interface de contact.

10. Une méthode servant à tester un micromodule de type double interface conformément à la revendication précédente, sachant que le test de l'interface sans contact est réalisé par une antenne simulée (21).

11. Une méthode de fabrication d'une carte à puce à double interface comprenant les étapes suivantes :
a) fabrication d'un micromodule à double interface,
b) test du micromodule à double interface,
c) connexion d'une antenne sur l'interface sans contact du micromodule,
d) insertion du micromodule et de son antenne connectée sur une carte en plastique,
sachant que le micromodule est testé conformément aux revendications 8 à 10.
